# EUROPEAN PATENT APPLICATION

(11) **EP 2 685 506 A1**
(43) Date of publication of application: **15.01.2014**
(21) Application number: 13170200.3
(22) Date of filing: 03.06.2013
(51) Int. Cl.: H01L 29/786, H01L 29/66, H01L 29/417, H01L 29/45

(54) **Thin-film transistor, electronic circuit, display and method of manufacturing the same**

(30) Priority: 12.07.2012 US 201213548133
(71) Applicant: Creator Technology B.V., 4837 BN Breda (NL)
(72) Inventor: O'Neill, Kevin Michael, 4837 BN Breda (NL); Maas, Joris P.V., 4837 BN Breda (NL)
(74) Representative: Goddar, Heinz J.

(57) **Abstract**

A bottom gate bottom contact thin-film transistor including a gate electrode, a source electrode, a drain electrode, a dielectric layer and a semiconductor layer of a semiconducting oxide is disclosed. The dielectric layer is arranged between the gate electrode and the semiconductor layer structure, and the source electrode and the drain electrode are covered with said semiconductor layer structure The source electrode and the drain electrode include at least a first electrode portion of an oxygen reducing material, and a second electrode portion of an additional material different from said oxygen reducing material wherein the second electrode portion of the drain at a side facing the source exposes to said semiconductor layer structure at least a surface portion of a main surface of its first electrode portion facing away from the dielectric layer, and wherein the second electrode portion of the source at a side facing the drain exposes to said semiconductor layer structure at least a surface portion of a main surface of its first electrode portion facing away from the dielectric layer.

## Description

### BACKGROUND

### Technical Field

The present invention relates to a thin-film transistor. The present invention further relates to an electronic circuit.

The present invention further relates to a display. The present invention further relates to a method of manufacturing a thin-film transistor. The present invention further relates to a method of manufacturing an electronic circuit. The present invention further relates to a method of manufacturing a display.

### Description of related Art

Today many display manufacturers choose for active matrix organic light emitting diode (AM-OLED) displays because of their thin and light construction, and the capability of low power consumption. Many of these displays employ crystallized silicon thin film transistors (TFTs) for their backplane, because crystallized silicon is stable in a high current flow, which is important for current-driven organic light-emitting devices. Recently semiconducting oxides have attracted attention because the manufacturing of semiconducting oxide TFTs is simpler than that of crystallized silicon TFTs and because a semiconducting oxide TFT has superior properties, such as a high on/off-current ratio. Apart from the on/off-current ratio, an important feature of a transistor is a high carrier mobility. In order to enable a high on-current, it is important to reduce the channel resistance.

### SUMMARY

According to a first aspect of the present invention there is provided a bottom gate bottom contact thin-film transistor. A bottom gate bottom contact thin-film transistor according to the first aspect of the invention comprises a gate electrode, a source electrode, a drain electrode, a semiconductor layer of a semiconducting oxide, and a dielectric layer arranged between the gate electrode and the semiconductor layer. The source electrode and the drain electrode are at least partially covered by the semiconductor layer and separated from each other by semiconducting material within the semiconductor layer. The bottom gate bottom contact thin-film transistor according to the first aspect of the invention is **characterized in that** the source electrode and the drain electrode comprise at least a first electrode portion of an oxygen reducing material, and a second electrode portion of additional material different from said oxygen reducing material, wherein the second electrode portion of the drain at a side facing the source exposes to said semiconductor layer structure at least a surface portion of a main surface of its first electrode portion facing away from the dielectric layer, and wherein the second electrode portion of the source at a side facing the drain exposes to said semiconductor layer structure at least a surface portion of a main surface of its first electrode portion facing away from the dielectric layer.

According to a second aspect of the present invention there is provided a method of manufacturing a bottom gate bottom contact thin-film transistor. The method according to the second aspect of the invention comprises subsequently providing a substrate, a gate metallization, a dielectric layer, a drain and a source, and a layer of a semiconducting oxide over the dielectric layer with the drain and the source. The method according to the second aspect is **characterized in that** the step of providing a drain and a source comprises providing a first electrode portion of an oxygen reducing material, and a second electrode portion of an additional material different from said oxygen reducing material. Therein the second electrode portion of the drain at a side facing the source exposes to said semiconductor layer structure at least a surface portion of a main surface of its first electrode portion facing away from the dielectric layer, and wherein the second electrode portion of the source at a side facing the drain exposes to said semiconductor layer structure at least a surface portion of a main surface of its first electrode portion facing away from the dielectric layer.

The bottom gate bottom contact thin-film transistor according to the first aspect has a high on/off-current ratio and a high carrier mobility. In the bottom gate bottom contact thin-film transistor according to the first aspect of the invention the first electrode portions (of the oxygen reducing material) of the drain electrode and the source electrode each have a surface portion at a main surface facing away from the dielectric layer and at mutually facing sides of the electrodes that is exposed to said semiconductor layer structure. Surprisingly it was found that this substantially reduces the resistance between source and drain. The bottom gate bottom contact thin-film transistor can be efficiently manufactured with the method according to the second aspect of the invention.

Moreover, it was found that this substantial reduction in resistance is obtained even in the case that the material of the second electrode portion has an electric conductivity higher than that of the material of the first electrode portion and wherein said first electrode portions laterally extend towards each other beyond the second electrode portions.

### BRIEF DESCRIPTION OF THE DRAWINGS

These and other aspects are described in more detail with reference to the drawing. Therein:
FIG. 1, 1A, and 1B show a first embodiment of a bottom gate bottom contact thin-film transistor according to the first aspect of the invention. Therein FIG. 1 shows a top-view, FIG. 1A shows a cross-section according to IA-IA in FIG. 1 and FIG. 1B shows enlarged portions IB as indicated in FIG. 1A.
FIG. 2 shows a portion of a bottom gate bottom contact thin-film transistor not according to the first aspect of the invention,
FIG. 3 shows experimental results obtained with specimens of bottom gate bottom contact thin-film transistors according to the first aspect of the invention, and with specimens of bottom gate bottom contact thin-film transistors not according to the first aspect of the invention,
FIG. 4 shows a top view of a second embodiment of a bottom gate bottom contact thin-film transistor according to the first aspect of the invention,
FIG. 4A shows enlarged portions in a cross-section according to IVA-IVA in FIG. 4,
FIG. 5A to 5D show a method of manufacturing a bottom gate bottom contact thin-film transistor according to the second aspect of the present invention,
FIG. 6A to 6E illustrates an alternative method of manufacturing a bottom gate bottom contact thin-film transistor according to the second aspect of the present invention,
FIG. 7 shows a top view of a third embodiment of a bottom gate bottom contact thin-film transistor according to the first aspect of the invention,
FIG. 7A shows enlarged portions in a cross-section according to VIIA-VIIA in FIG. 7,
FIG. 8 shows according to a corresponding cross-section an enlarged portion of a fourth embodiment of a bottom gate bottom contact thin-film transistor according to the first aspect of the invention,
FIG. 9 schematically shows a display panel comprising a plurality of pixels arranged in a matrix of rows and columns,
FIG. 10 shows an electric replacement scheme of a pixel of the display panel in FIG. 9,
FIG. 11 schematically shows a cross-section according to XI-XI in FIG. 9 through a single pixel in the display.

### DESCRIPTION OF THE EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

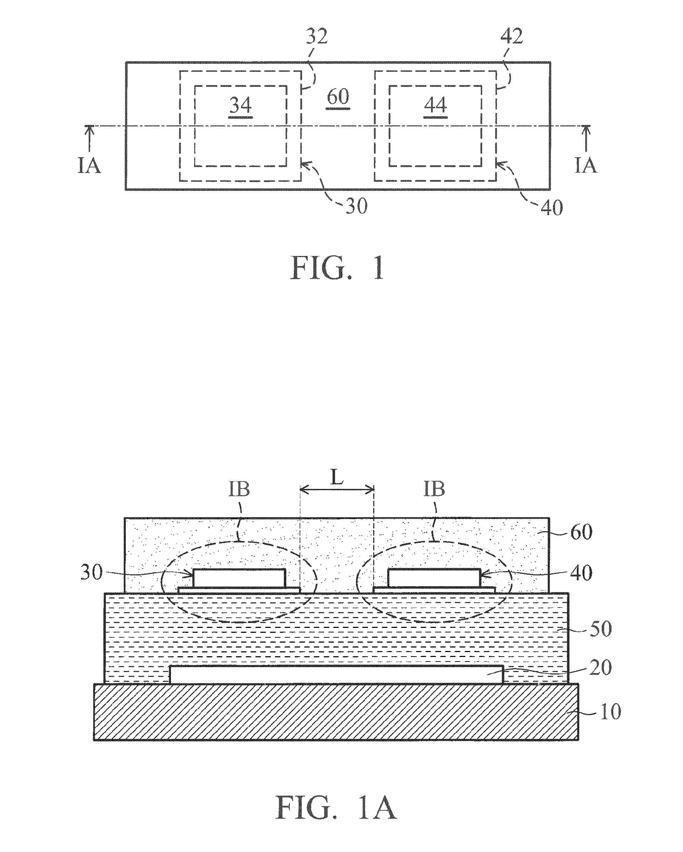

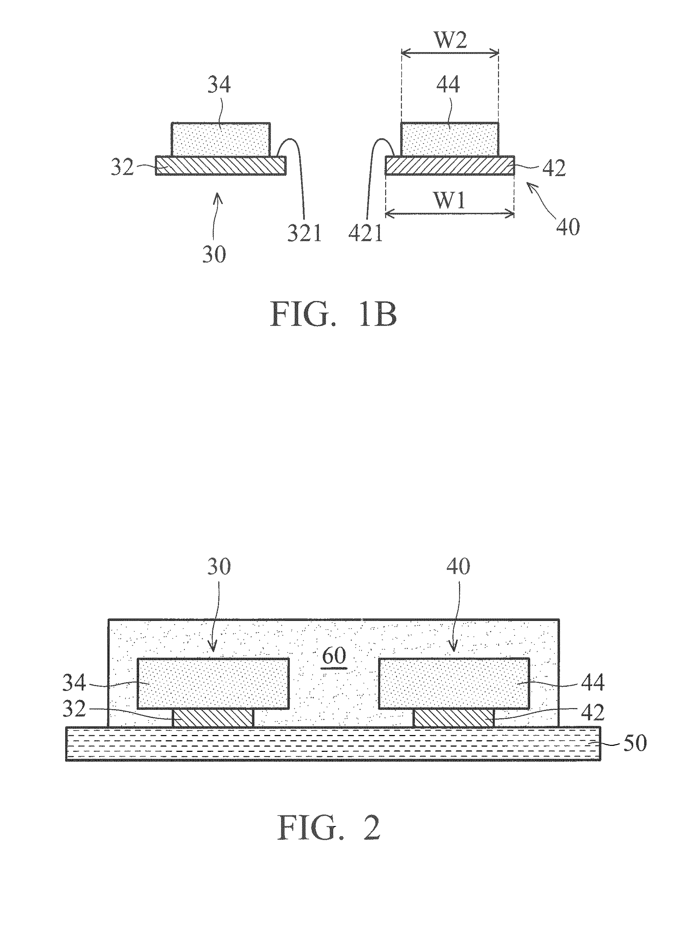

FIG. 1 schematically shows a bottom gate bottom contact thin film transistor in a top view. Therein hidden boundaries are shown by dashed lines. FIG. 1A shows a cross-section according to IA-IA in FIG. 1 and FIG. 1B shows enlarged portions IB as indicated in FIG. 1A. The thin film transistor shown in FIG. 1, 1A and 1B comprises a substrate 10 such as silicon, sheet metal, foil, foil-on-carrier, glass, carrying a gate electrode 20, a source electrode 30, a drain electrode 40, a dielectric layer 50, and a semiconductor layer 60 structure. The semiconductor comprises one or more layers of a semiconducting oxide.

The dielectric layer, which may be a single layer of silicon nitride, aluminium oxide, silicon oxide etc, or multilayer built up using any combination of these materials 50 is arranged between the gate electrode 20 and the semiconductor layer 60. The source electrode 30 and the drain electrode 40 are at least partially covered by the semiconductor layer 60 and separated from each other by semiconducting material within said semiconductor layer 60. The source and the drain electrodes 30, 40 may for example each have a lateral size of 10 x 10 µm. Dependent on the application the electrodes may be smaller or larger. It is not necessary that the electrodes 30, 40 have a rectangular shape. As an alternative, the electrodes may be formed as comb-like structures that grip into each other.

As can best be seen in FIG. 1B, showing enlarged portions according to IB in FIG. 1A, the source electrode 30 comprises a first electrode portion 32 of an oxygen reducing material, and a second electrode portion 34 of a different material. Likewise the drain electrode 40 comprises a first electrode portion 42 of an oxygen reducing material, and a second electrode portion 44 of a different material. FIG. 1, 1A and 1B further show that the first electrode portions 32, 42 of the source 30 and the drain 40 laterally extend towards each other beyond the second portions 34, 44. Therewith the second electrode portion 44 of the drain 40 at a side facing the source 30 exposes to said semiconductor layer structure 60 at least a surface portion 421 of a main surface of its first electrode portion 42 facing away from the dielectric layer 50. The second electrode portion 34 of the source 30 at a side facing the drain 40 exposes to said semiconductor layer structure 60 at least a surface portion 321 of a main surface of its first electrode portion 32 facing away from the dielectric layer 50.

In the embodiment shown the semiconducting oxide is amorphous-gallium-indium-zinc-oxide (a-GIZO). However, alternative semiconducting oxides may be used, such as HfInZnO, GaInSnO, InZnO, InSnZnO and ZnSnO. The semiconductor layer structure 60 may comprise one or more layers of a semiconducting oxide, for example two layers having a mutually different electrical conductivity. It appears that the upper layer protects the lower layer(s). A diffusion region may be formed between the semiconducting oxide layers. In an embodiment layers of the same semiconducting oxide may be applied, e.g. a first and a second layer of gallium-indium-zinc-oxide having a mutually different electrical conductivity.

The first electrode portions 32, 42 of the source and the drain electrode 30, 40 are of an oxygen reducing material selected from the group of Ti, Cr, Sn, Zr, Al, V, Fe or an alloy thereof. In this case the selected material is Ti. The materials of this group are believed to provide a particularly good interface with the semiconducting oxide.

The second electrode portions 34, 44 of the source and the drain electrode 30, 40 are of a second material selected from Au, W, Mo, MoCr alloy, AlNd alloy, indiumtinoxide (ITO), Cu, Al, Ni in a single-layer configuration or multilayer configuration using any combination of these materials. In this case Au is applied as the material for the second electrode portions 34, 44. Ti has a specific electric conductivity of 2.38×10⁶ S/m. Au has a higher specific electric conductivity of 4.52×10⁷ S/m.

In the embodiment shown the first and the second electrode portion of the source electrode 30 are a first and a second layer 32, 34 and the first layer 32 is arranged between the dielectric layer 50 and the second layer 34. Likewise, the first and the second portion of the drain electrode 40 are a first and a second layer 42, 44 and the first layer 42 is arranged between the dielectric layer 50 and the second layer 44.

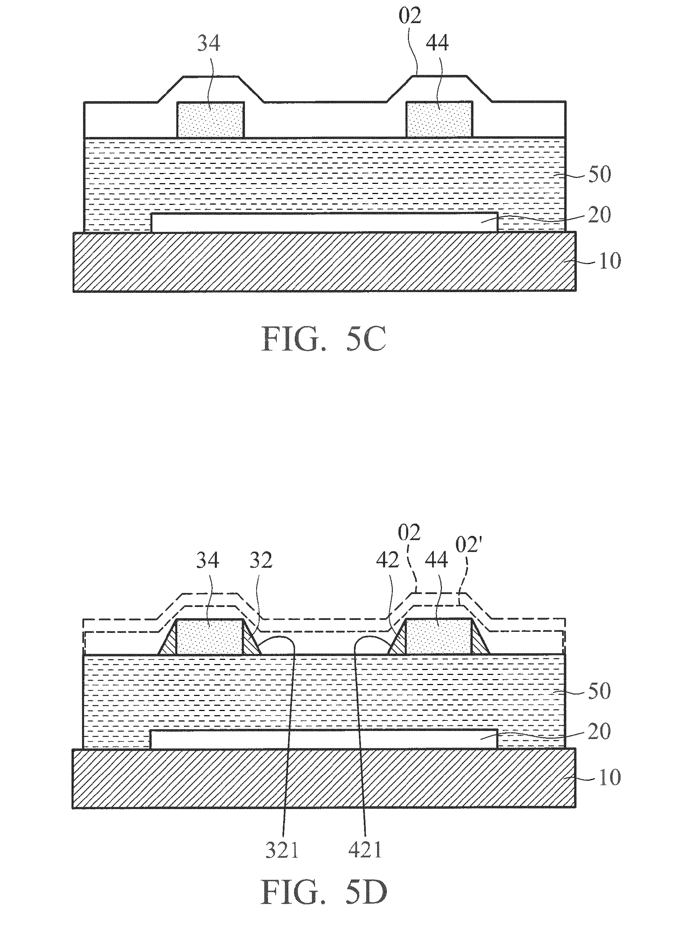

It is sufficient that the first, oxygen reducing layer 32 has a thickness in the same order of magnitude as the accumulation channel formed, i.e. in the order of magnitude of a few nanometer, for example 1 to 10 nm, e.g. 3 to 8 nm. However, alternatively a thicker oxygen reducing layer may be applied, e.g. as shown for an another embodiment in FIG. 5D.

The second layer 34 has a thickness in the range of at least 10 nanometers, e.g. in the range of 10 to 100 nm, preferably in the range of 20 to 50 nm. The relatively high thickness of the second layer enables a good lateral conduction.

In order to determine the influence of the relative position of the first electrode portion 32, 42 and the second electrode portion 34, 44 of the electrodes, specimens were made both of thin film transistors according to the first aspect of the invention as well as thin film transistors not according to the invention.

FIG. 2 schematically shows a source electrode 30 of a thin film transistor not according to the present invention. The drain electrode 40 has a similar structure. Contrary to the thin film transistor according to the first aspect of the invention, the first electrode portion 32 of the source 30 does not have a surface portion facing away from the dielectric layer 50 that is exposed to the semiconductor layer structure 60. Likewise, the first electrode portion 42 of the drain 40 does not have a surface portion facing away from the dielectric layer 50 exposed to the semiconductor layer structure 60.

Various samples of the bottom gate bottom contact thin film transistor according to the first aspect were prepared by a method according to second aspect with the following steps. A silicon substrate is provided. Alternatively a substrate of another inorganic material or an organic substrate, e.g. a polymer, such as PEN or PET may be used as the substrate. The gate metal layer, here of Au, is deposited on the substrate with a physical vapour deposition process. Alternative methods, such as printing may be used for deposition of the gate metal layer. The gate metal layer may also be patterned after deposition, using standard photolithographic techniques, e.g. by a lift-off process. The dielectric layer, here silicon nitride, is then deposited by plasma enhanced chemical vapour deposition. Finally the source and drain electrode multilayers are deposited, with titanium as the first, lowest layer of an oxygen reducing material and gold as the second, top layer. Both layers were deposited with a physical vapour deposition process.

After photolithographic patterning using a resist mask and etching the gold with standard gold wet-etch solution, e.g. an iodine based solution or a cyanide based solution, the titanium layer is wet etched using standard titanium wet-etch solution, against which the gold and silicon nitride is chemically stable, e.g. a standard wet etch solution consisting of 35% HCl in water. Alternatively, a titanium dry etching technique may be applied. After resist stripping the a-GIZO is applied using reactive sputtering over the dielectric layer with the drain and the source.

The patterned first and second layers may alternatively be obtained by masked vapor deposition process. Therewith a single mask may be used for both layers.

Subsequently a second Au etch step is applied. Therewith a rim of the second electrode portions 34, 44 of the source 30 and the drain 40 is removed. This has the effect that a main surface of the first electrode portions 32, 42 facing away from the dielectric layer 50 is partially exposed to the semiconductor layer structure 60 after the latter is deposited. The partially exposed main surface of the first electrode portion 32 of the source 30 comprises at least an exposed surface portion 321 at a side facing the drain 40 and the partially exposed main surface of the first electrode portion 42 of the drain 40 comprises at least an exposed surface portion 421 at a side facing the source 30. This second Au etch step also has the effect that the underlying layer 32 extends beyond the layer 34 towards the other electrode.

According to this preparation method, samples A of bottom gate bottom contact thin film transistors according to the first aspect of the present invention were prepared having a channel length L of 2.5 µm, 5 µm, 10 µm and 20 µm. By applying an Au etching with different durations, i.e. during 5 s, 10 s and 15 s, three types of samples were prepared.

In addition samples B of bottom gate bottom contact thin film transistors not according to the present invention were prepared. The method according to which they were prepared differs from the method according to the second aspect described in the previous paragraph in that the second Au etching step is omitted, but that instead, after application of the dual layer the Ti layer is further etched in the HCl solution for 2 minutes. With this method not according to the invention samples were prepared with channel length L, measured from the edge of the electrodes, of 2.5 µm, 5 µm, 10 µm and 20 µm. For both samples A and samples B, the first layer 32 had a thickness of 5 nm and the second layer 34 had a thickness of 25 nm.

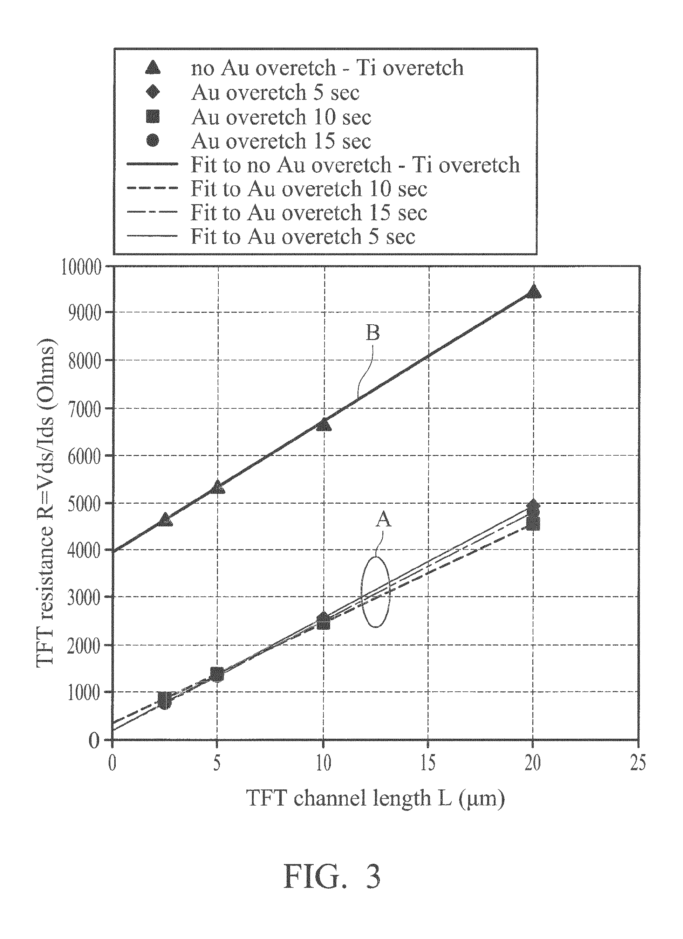

For each of the prepared samples the TFT-resistance R (Vds/Ids) was measured. The results are shown in FIG. 3 as a function of the channel length L. In FIG. 3 it can be seen that for both the samples A according to the first aspect of the invention and the samples B not according to the invention, the resistance is a linearly increasing function of the channel length L. However, it is noted that for the samples B not according to the present invention the measured resistance is relatively high, even for a very short channel length. In particular for a channel length of 2.5 µm, the measured resistance is still about 4.5 kΩ. Extrapolation of the data obtained for the samples not according to the invention suggests an offset of about 4 kΩ.

Contrary thereto, the measured resistance for the samples A according to the first aspect of the present invention is relatively low. In particular for a channel length of 2.5 µm, the measured resistance is about 1 kΩ. Extrapolation of the data obtained for the samples according to the first aspect of the invention indicates an offset of only about 200 Ω. Accordingly the measure of the present invention results in a substantially lower TFT-resistance. Hence, even despite the fact that the layer 34 has a higher conductivity than the underlying layer 32 of oxygen reducing material, a lower TFT resistance is obtained for the samples according to the present invention, wherein this underlying layer 32 extends beyond the layer 34 towards the other electrode.

As an alternative for Ti as the oxygen reducing material one of the materials, Cr, Sn, Zr, Al, V, Fe or an alloy thereof may be used for example. The additional material used for the second electrode portion, and different from the oxygen reducing material used for the first electrode portion may also be selected from W, Mo, MoCr alloy, AlNd alloy, indiumtinoxide(ITO),Al, Cu, and Ni for example.

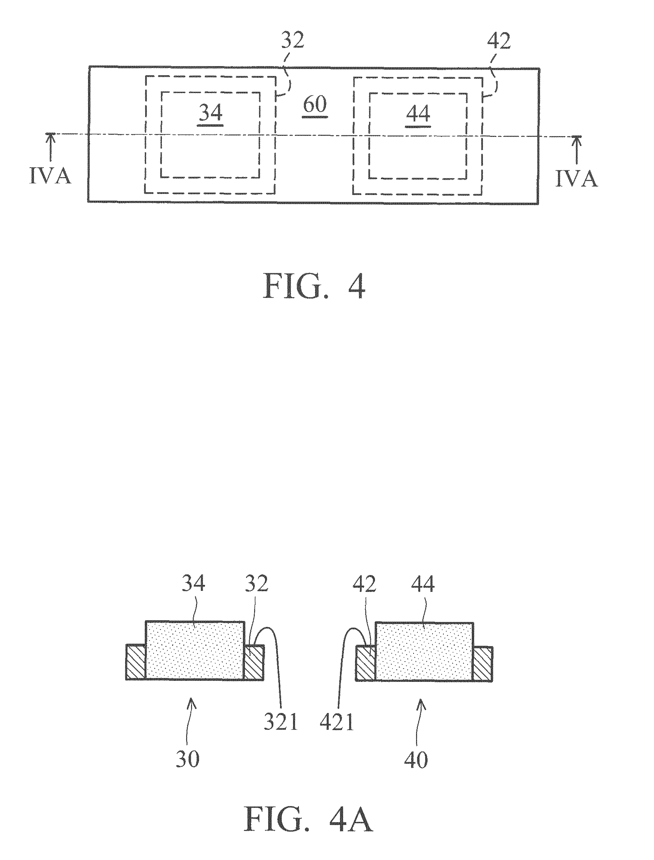

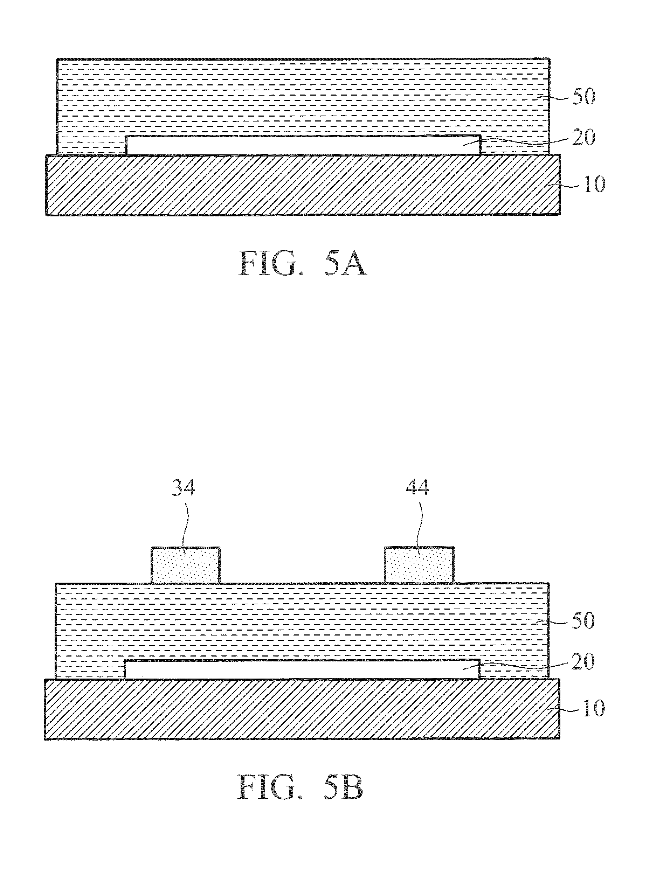

FIG. 4 and 4A show another embodiment of a bottom gate bottom contact thin film transistor according to the first aspect of the invention. Therein FIG. 4 shows a top view and FIG. 4A shows enlarged portions in a cross-section according to IVA-IVA in FIG. 4. In this embodiment the layer 32, 42 of oxygen reducing material is applied as a ring around the layer 34, 44 of the additional material, different from the oxygen reducing material. This embodiment is advantageous in that it allows for a very efficient method of manufacturing as described with reference to FIG. 5A - 5D.

FIG. 5A shows a semi-finished product comprising the substrate 10, the gate electrode 20 and the dielectric layer 50.

As shown in FIG. 5B, starting from this semi-finished product a second layer is deposited of an additional material, different from the oxygen reducing material to be used for the first layer. The material is deposited according to a pattern comprising mutually disjunct lateral electrode portions 34, 44 for the source and the drain. Various options are possible for this deposition process. The pattern may be obtained by a patterned deposition process, e.g. using a masked vapor deposition process, or may be obtained by patterning after deposition, e.g. by selective etching. Also a lift-off process may be used.

As shown in FIG. 5C, subsequently the oxygen reducing material is deposited blanketwise, so that the mutually disjunct lateral electrode portions 34, 44 and at least part of the dielectric layer 50 surrounding these lateral electrode portions is covered by a layer 02 of the oxygen reducing material.

As shown in FIG. 5D, the layer 02 is subsequently anisotropically etched in a direction transverse to the substrate, with intermediate result 02' and finally resulting in ring shaped electrode portions 32, 42 of the oxygen reducing material around the electrode portions 34, 44. The second electrode portion 34 of the source 30 exposes a main surface of the first electrode portion 32 facing away from the dielectric layer 50. Likewise the second electrode portion 44 of the drain 40 exposes a main surface of the first electrode portion 42 facing away from the dielectric layer 50. Consequently, the main surfaces of the first electrode portions 32, 42 of the source and the drain 30, 40 therewith are exposed to the semiconductor layer structure 60 after the latter is deposited. The exposed main surface of the first electrode portion 32 of the source 30 has an exposed surface portion 321 at a side facing the drain 40 and the exposed main surface of the first electrode portion 42 of the drain 40 has an exposed surface portion 421 at a side facing the source 30.

First electrode portions 32, 42 having these surface portions 321, 421 laterally extend towards each other beyond the second electrode portions 34, 44.

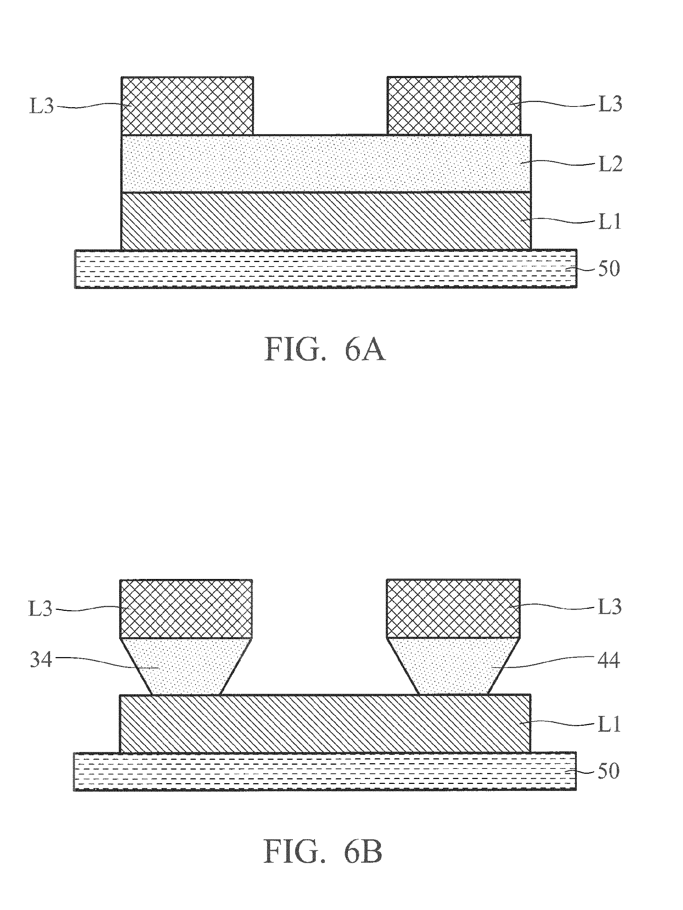

FIG. 6A to 6E illustrate an alternative method, that differs from the method depicted in FIG. 5A to 5D in the way wherein a drain and a source are provided. As shown in FIG. 6A, the drain and the source are provided by the following subsequent steps.

In a first step a first layer L1 of the oxygen reducing material is deposited from which the first electrode portion 32, 42 of the source 30 and the drain 40 is to be formed.

In a second step a second layer L2 of an additional material is deposited over the first layer L1. The second electrode portion 34, 44 of the source 30 and the drain 40 is to be formed from this second layer L2.

In a third step a resist mask L3 is applied over the second layer having a pattern that corresponds to the pattern of the second electrode portion 34, 44 of the source 30 and the drain 40 to be formed.

The result of these first, second and third steps is shown in FIG. 6A.

In a fourth step illustrated in FIG. 6B, the second layer L2 is wet etched. Therewith under etched second electrode portions 34, 44 of the source 30 and the drain 40 are formed.

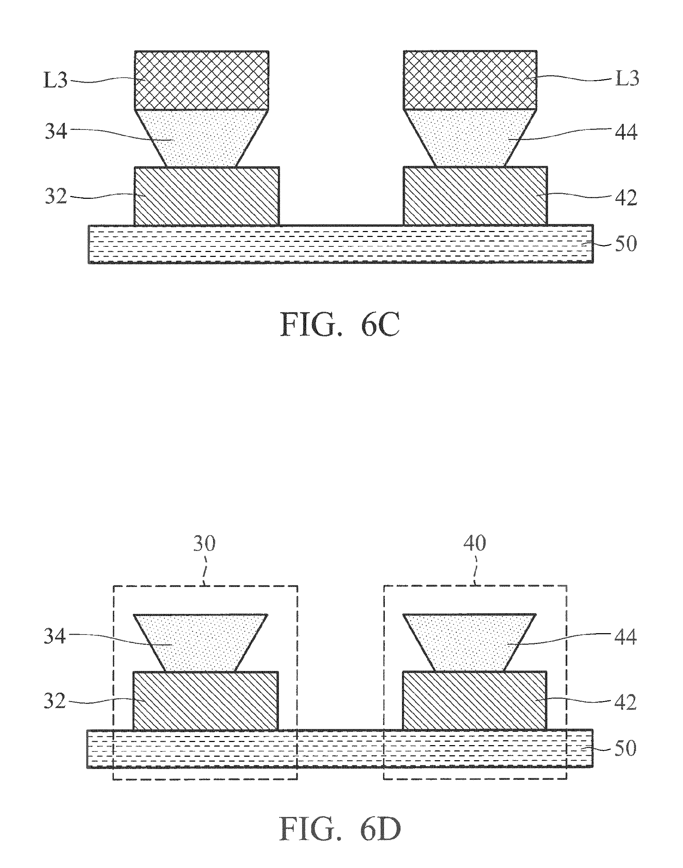

In a fifth step illustrated in FIG. 6C, the first layer L1 is dry etched. Therewith second electrode portion 32, 42 of the source 30 and the drain 40 are formed, showing no under etching.

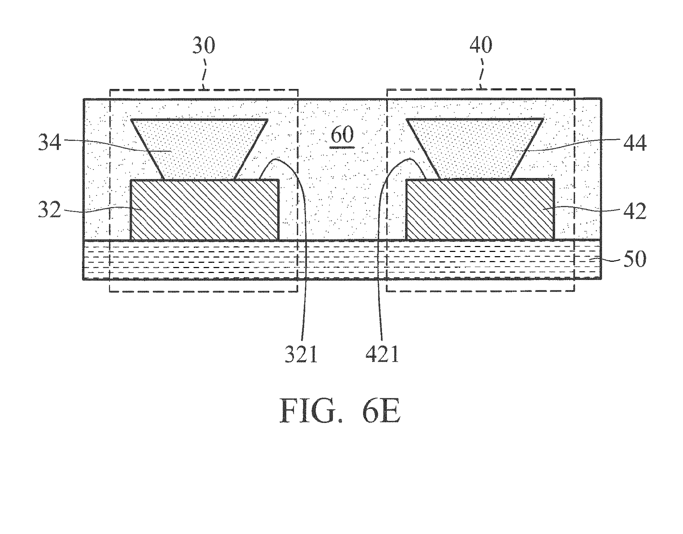

In a sixth step illustrated in FIG. 6D, the resist mask L3 is removed. Subsequently, in a seventh step, illustrated in FIG. 6E, the semiconductor layer structure 60 comprising at least one layer of a semiconducting oxide is deposited over the electrodes 30, 40. As in the fourth step illustrated in FIG. 6B, the second layer L2 is wet etched, under etched second electrode portion 34, 44 of the source 30 and the drain 40 are formed that partially expose to said semiconductor layer structure a main surface of its first electrode portion 32, 42 facing away from the dielectric layer 50. The partially exposed main surface of the first electrode portion 32 of the source 30 comprises at least a surface portion 321 at a side facing the drain 40 and the partially exposed main surface of the first electrode portion 42 of the drain 40 comprises at least a surface portion 421 at a side facing the source 30.

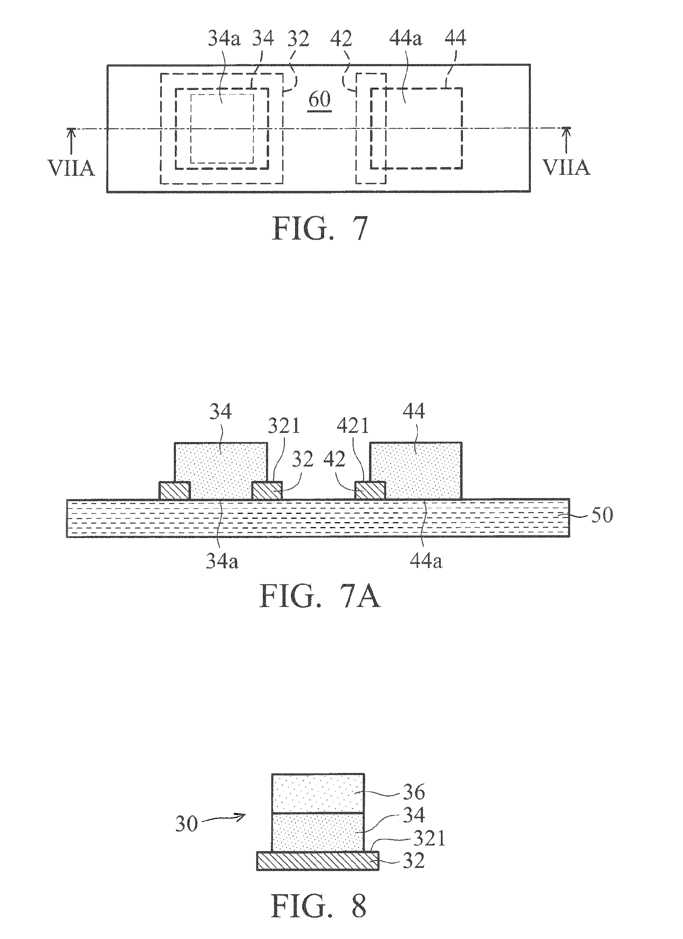

FIG. 7 and 7A show a still further embodiment of bottom gate bottom contact thin-film transistor according to the first aspect of the present invention. Therein FIG. 7 shows a top view and FIG. 7A shows enlarged portions in a cross-section according to VIIA-VIIA in FIG. 7. In this further embodiment the second layer 34, 44 of at least one of the source electrode 30 and the drain electrode 40 partly is arranged against the dielectric layer 50 in an area 34a, 44a remote from an area where the first layer laterally extends towards the first layer of the other one of the source electrode and the drain electrode. Therewith the second electrode portion 44 of the drain 40 at a side facing the source 30 exposes to the semiconductor layer structure 60 at least a surface portion 421 of a main surface of its first electrode portion 42 facing away from the dielectric layer 50. Likewise, the second electrode portion 34 of the source 30 at a side facing the drain 40 exposes to said semiconductor layer structure 60 at least a surface portion 321 of a main surface of its first electrode portion 32 facing away from the dielectric layer 50.

FIG. 8 shows a portion of a still further embodiment of a bottom gate bottom contact thin-film transistor according to the first aspect of the present invention. The portion shown is a source 30. The source 30 differs from the source of the thin-film transistor FIG. 1, 1A and 1B in that a third layer 36 is arranged upon the second layer 34. The additional, third layer 36 may contribute to a better adhesion of other components to the source 30, such as a conductor to a further electric component. In advantageous embodiments the first, the second and the third layer 32, 34, 36 respectively are Ti, Al, Mo or Ti, Al, Ti. Additionally, the third layer may serve a coating that prevents that an (insulating) oxide layer is formed on the second layer. Therewith, in addition to a better mechanical connection, also a better electrical connection with such other components can be obtained. The third layer typically has a thickness of a few nm, e.g. 5 nm.

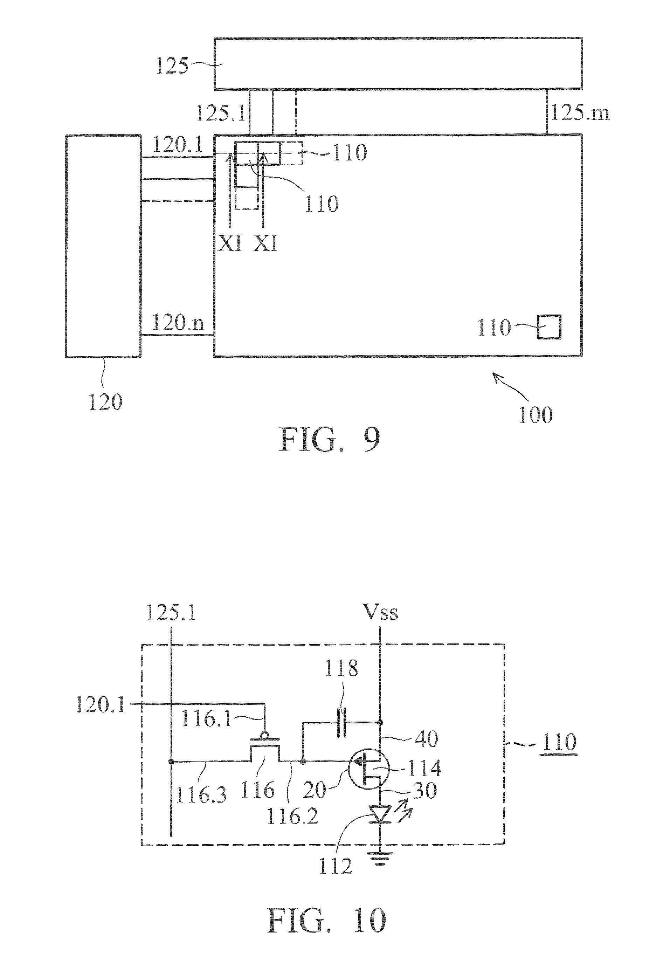

FIG. 9 schematically shows a display panel 100 comprising a plurality of pixels 110 arranged in a matrix of rows and columns. The display panel further comprises a first and a second decoder 120, 125. The first decoder 120 has outputs 120.1 - 120.n each for providing a selection signal to a respective row of the matrix. The second decoder 125 has outputs 125.1 - 125.m each for providing a data signal to a respective column of the matrix.

FIG. 10 shows an electronic circuit. The electronic circuit is an electric replacement scheme of a pixel 110. By way of example the pixel 110 is shown that has a select input coupled to the output 120.1 of the first decoder 120 and a data input coupled to the output 125.1 of the second decoder 125. The other pixels, each coupled to a pair of outputs, one of the decoder and one of the second decoder are similar.

The pixel 110 comprises an electro-optic element 112, here an OLED and an electronic device with at least one driver transistor 114 and at least one selection transistor 116.

The driver transistor 114 has a first control electrode 20, and a first channel of a semiconducting material extending between a first main electrode 40 and a second main electrode 30.

The selection transistor 116 has a third main electrode 116.2 and a fourth main electrode 116.3 coupled by a second channel of a semiconducting material and a second control electrode 116.1. In the embodiment shown, the selection transistor 116 is of the n-type. However, alternatively a p-type selection transistor may be applied.

The first control electrode 20 of the driver transistor 114 of the electronic device is coupled to the third main electrode 116.2 of the selection transistor 116. The electro-optic element 112 has a first terminal coupled to the second main electrode 30 of the driver transistor 114. The first control electrode 116.1 of the selection transistor 116 is coupled to the output 120.1 of the first decoder 120. The second main electrode 116.3 of the selection transistor 116 is coupled to the output 125.1 of the second decoder 120. The first main electrode 40 of the driver transistor 114 is coupled to the power supply line Vss and the electro-optic element 112 has a further terminal coupled to a reference voltage supply. A capacitive element 118 is provided between the first control electrode 20 and the first main electrode 40 of the driver transistor 114.

The selection transistor 116 is controlled by the output signal 120.1 of the first decoder 120. If the selection signal at 120.1 is activated the capacitor 118 is charged to the value available at the output line 125.1 from the second decoder 125. If the selection signal provided by output 120.1 is deactivated, the voltage at the charged capacitor 118 determines the value of the drive current provided by the driver transistor 114 to the electro-optic device 112.

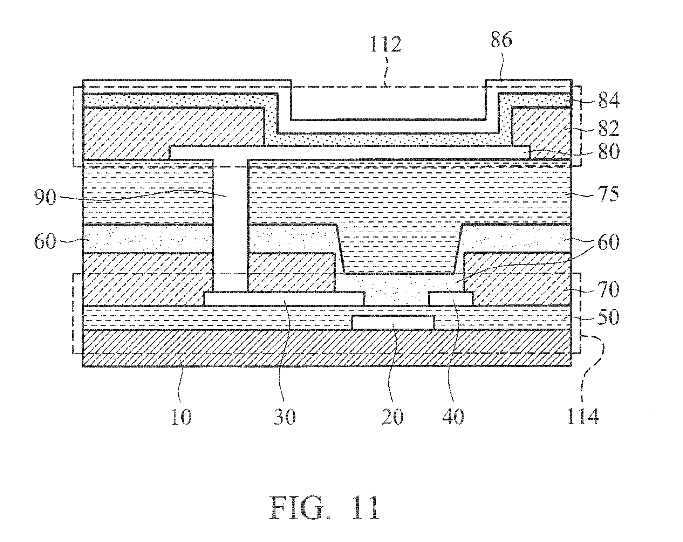

FIG. 11 schematically shows a cross-section according to XI-XI in FIG. 9 through a single pixel in the display. For clarity only the driver transistor 114 and the electro-optic element 112 are shown therein. The driver transistor 114 is provided as a bottom gate bottom contact thin-film transistor according to the first aspect of the present invention. The selection transistor 116 (not shown in FIG. 11) may be provided analogously.

Parts corresponding to those in FIG. 1 and in FIG. 11 have the same reference numbers. In addition to the product shown in FIG. 1, the product shown in FIG. 11 comprises a second dielectric layer 70, a third dielectric layer 75 and a display layer 112 comprising various sub-layers. The sub-layers of the display layer 112 comprise a fourth dielectric layer 82, a patterned metallization layer 80, and a transparent electrically conductive layer 86, that respectively form an anode and a cathode of the display layer 112, as well as a light-emitting layer 84 arranged between the anode and the cathode layer 80, 86. In the embodiment shown in FIG. 11, the display is of a top-emission type. In case of a bottom emission type the layer 80 should be of a transparent electrically conductive material. In that case it is not necessary that the layer 86 is transparent.

A portion of the patterned metallization layer 80 is coupled via a transverse connection 90 to the second main electrode 30 of the driver-transistor 114.

The product of FIG. 9 to 11 may be obtained starting from a product shown in FIG. 1A, FIG. 4, FIG. 5D,FIG. 7 and FIG. 8. This may be achieved by the following steps.
- Depositing a second dielectric layer 70, that leaves open a space between the electrodes 30, 40 of the transistor 114. For clarity, in FIG. 11 the electrodes 30, 40 are shown as a single layer. The electrodes 30, 40 however each comprise a first and a second layer 32, 34; 42, 44 as shown in FIG. 1A, FIG. 4, FIG. 5D and FIG. 7 and optionally one ore more further layers as shown in FIG. 8 for example.
- depositing the semiconductor layer 60 of a semiconducting oxide.
- depositing a third dielectric layer 75.
- providing a transverse electric connection 90 towards the second electrode 30. This may be achieved by laser drilling an opening and filling the opening so obtained with an electrically conductive paste or by lithographic processing.
- depositing a patterned metal layer 80 having portions that electrically connect with a respective transverse electrical conductor,
- depositing a third, patterned dielectric layer 82, having openings that expose the portions of the patterned metal layer 80,
- depositing at least one layer 84 of a light-emitting material,
- depositing a layer 86 of a transparent electrically conductive material forming a cathode.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. All publications, patent applications, patents, and other references mentioned herein are incorporated by reference in their entirety. In case of conflict, the present specification, including definitions, will control. In addition, the materials, methods, and examples are illustrative only and not intended to be limiting.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

## Claims

1. A bottom gate bottom contact thin-film transistor comprising:
a gate electrode;
a source electrode;
a drain electrode;
a dielectric layer; and
a semiconductor layer structure comprising at least one layer of a semiconducting oxide;
wherein said dielectric layer is arranged between said gate electrode and said semiconductor layer, and wherein said source electrode and said drain electrode are covered with said semiconductor layer and separated from each other by semiconducting material within said semiconductor layer,
**characterized in that** the source electrode and the drain electrode comprise at least a first electrode portion of an oxygen reducing material, and a second electrode portion of an additional material different from said oxygen reducing material, the first electrode portions having a main surface facing away from the dielectric layer, wherein at a side facing the source the main surface of the first electrode portion of the drain has at least a surface portion exposed to said semiconductor layer structure and wherein at a side facing the drain the main surface of the first electrode portion of the source has at least a surface portion exposed to said semiconductor layer structure.

2. The thin-film transistor according to claim 1, wherein said additional material has an electric conductivity higher than that of said oxygen reducing material.

3. The thin-film transistor according to claim 1 or 2, wherein said oxygen reducing material is selected from Ti, Cr, Sn, Zr, V, Fe or an alloy thereof.

4. The thin-film transistor of one of the preceding claims, wherein said additional material is selected from Au, W, Mo, MoCr alloy, AlNd alloy, indiumtinoxide (ITO), Al, Cu, Ni.

5. The thin-film transistor of one of the preceding claims, wherein the first and the second electrode portion are a first and a second layer respectively, and wherein the first layer is arranged between the dielectric layer and the second layer.

6. The thin-film transistor of claim 5, wherein a third layer is arranged upon the first layer and the second layer.

7. The thin-film transistor of claim 6, wherein the first layer, the second layer and the third layer respectively are a titanium layer, an aluminum layer and a molybdenum layer.

8. The thin film transistor according to one of the preceding claims, wherein the second electrode portion of at least one of the source electrode and the drain electrode at least partly is in direct contact with the dielectric layer in an area remote from an area where the first electrode portion faces the other one of the source electrode and the drain electrode.

9. The thin-film transistor of one of the preceding claims, wherein said at least one layer of said semiconducting oxide layer structure comprise indium-gallium-zinc-oxide .

10. A display comprising an electronic circuit including at least one thin film transistor according to one of the previous claims., the display having a plurality of display elements controlled by respective driver transistors in the electronic circuit.

11. A method of manufacturing a bottom gate bottom contact thin film transistor, comprising the subsequent steps of:
providing a substrate;
providing a gate metallization;
providing a dielectric layer;
providing a drain and a source; and
providing a semiconductor layer structure comprising at least one layer of a semiconducting oxide over the dielectric layer with the drain and the source,
**characterized in that** the step of providing a drain and a source comprises:
providing a first electrode portion of an oxygen reducing material; and
providing a second electrode portion of an additional material different from said oxygen reducing material, wherein the first electrode portions has a main surface facing away from the dielectric layer, wherein at a side facing the source the main surface of the first electrode portion of the drain has at least a surface portion exposed to said semiconductor layer structure, and wherein at a side facing the drain the main surface of the first electrode portion of the source has at least a surface portion exposed to said semiconductor layer structure.

12. The method according to claim 11, wherein the first and the second electrode portion respectively are provided as a first and a second layer, wherein the second layer is deposited according to a pattern comprising respective, mutually disjunct lateral portions for the drain and the source respectively, and wherein the first layer is deposited blanketwise over these lateral portions, followed by a step of anisotropically etching the first layer in a direction transverse to the substrate.

13. The method according to claim 11 or 12, wherein the step of providing a drain and a source comprises:
depositing a first layer of said oxygen reducing material;
depositing a second layer of said additional material over the first layer;
applying a resist mask over the second layer having a pattern corresponding to said second portion;
wet etching the second layer; and
diy etching the first layer.

14. The method of manufacturing an electronic circuit comprising manufacturing at least one bottom gate bottom contact thin film transistor according to the method of one of the claims 11 to 13.

15. The method according to one of claims 11 to 14, further including the following steps:
after the step of providing a drain and a source, forming a first and a second electrode, and before the step of providing the semiconductor layer structure, depositing a second dielectric layer, that leaves open a space between the electrodes of the transistor;
depositing a third dielectric layer;
providing a transverse electric connection through the second dielectric layer, the third dielectric layer and the semiconductor layer structure towards one of the first and the second electrodes;
depositing a patterned metal layer having lateral portions that electrically connect with a respective transverse electrical conductor;
depositing a fourth, patterned dielectric layer, having openings that expose the portions of the patterned metal layer;
depositing at least one layer of a light-emitting material; and
depositing a layer of a transparent electrically conductive material forming a cathode.
